## Europäisches Patentamt
## European Patent Office
## Office européen des brevets

(19)

(11) Numéro de publication: **0 009 442**
A1

(12) **DEMANDE DE BREVET EUROPEEN**

(21) Numéro de dépôt: **79400640.3**

(22) Date de dépôt: **13.09.79**

(51) Int. Cl.³: **H 01 L 29/72**, H 01 L 21/82, H 01 L 29/10, H 01 L 27/02

(30) Priorité: **15.09.78 FR 7826554**

(43) Date de publication de la demande: **02.04.80** Bulletin 80/7

(84) Etats contractants désignés: **BE CH DE GB IT NL SE**

(71) Demandeur: **"THOMSON-CSF", 173, boulevard Haussmann, F-75360 Paris Cedex 08 (FR)**

(72) Inventeur: **Roche, Marcel, "THOMSON-CSF" - SCPI 173, bld Haussmann, F-75360 Paris Cedex 08 (FR)**

(74) Mandataire: **Favre, Maurice et al, "THOMSON-CSF" - SCPI 173, bld Haussmann, F-75360 Paris Cedex 08 (FR)**

(54) **Transistors bipolaires à tension élevée, circuits intégrés comportant de tels transistors, et procédé de fabrication de tels circuits.**

(57) L'invention se rapporte au domaine des transistors bipolaires pour fonctionnement aux tensions élevées, supérieures à 100 V. La fabrication simultanée de ces transistors des différents types connus, à savoir pnp, pnp latéraux, non et I2L, en vue de les réunir par intégration monolithique sur un même substrat, rencontre de grandes difficultés par suite des incompatibilités entre certaines étapes de fabrication communes. Selon l'invention, il est créé, pour les surmonter dans les pnp et pnp latéraux, deux régions supplémentaires à taux de dopage élevé de signe n, l'une à la jonction d'émetteur (32), et l'autre à la jonction de collecteur (25). Les applications sont notamment relatives aux circuits intégrés pour tensions élevées à haut degré d'intégration.

# TRANSISTORS BIPOLAIRES A TENSION ELEVEE, CIRCUITS INTEGRES COMPORTANT DE TELS TRANSISTORS, ET PROCEDE DE FABRICATION DE TELS CIRCUITS

La présente invention concerne le domaine des dispositifs électroniques à semiconducteurs, connus sous le nom de transistors, et se rapporte plus particulièrement au cas où un grand nombre de transistors est réuni et interconnecté sur un bloc unique de matériau semiconducteur, suivant les techniques de l'intégration monolithique. L'évolution vers les degrés croissants d'intégration à haute densité a conduit à des dimensions décroissantes de tous les éléments des circuits intégrés, posant alors le problème de l'isolement électrique entre ceux-ci, d'autant plus critique que, dans de nombreuses applications, se manifeste la nécessité de faire appel à un fonctionnement à des tensions électriques plus élevées.

Les divers types de transistors d'un usage le plus répandu dans la technique, connus sous le nom de "n-p-n", "p-n-p substrat", "p-n-p latéral", et "Integrated Injection Logic" peuvent entrer simultanément dans la constitution de circuits intégrés pour tensions normales et l'on connaît les modifications qu'il est nécessaire d'apporter à leurs paramètres de réalisation, tels que certaines de leurs régions, pour augmenter sans danger leurs tensions électriques de fonctionnement.

Cependant un grave inconvénient à la mise en oeuvre de ces modifications apparaît lors de l'intégration, lié au fait que, alors que ces divers types de transistors sont réunis sur le même bloc, certains de leurs paramètres de réalisation respectifs deviennent incompatibles entre eux, la même étape de fabrication devant par exemple produire deux régions de dopage totalement différent dans deux transistors de type différent du circuit intégré.

Il en résulte une néfaste limitation dans la conception des circuits intégrés à tension élevée, où n'est alors permise que l'adoption d'un seul type de transistor à la fois. En pratique, c'est le type n-p-n qui est adopté, par suite notamment de ses meilleurs caractéristiques en fréquence.

C'est l'objet de la présente invention que de proposer des transistors des autres types cités, dont la structure particulière les rend aptes d'une part à un fonctionnement à tension électrique élevée, de l'ordre de 100 volts, et d'autre part à une fabrication en circuit intégré monolithique à haute tension entièrement compatible avec la fabrication simultanée de transistors de type n-p-n.

C'est un autre objet de l'invention que de proposer un procédé de réalisation simultané de ces transistors, inclus dans des circuits intégrés monolithiques à haute tension.

Cependant, pour bénéficier entièrement des avantages procurés par l'invention, il est indispensable de réaliser avec une grande précision les distances entre les murs latéraux d'isolement et les régions p servant de base aux transistors npn, ce qui, tout en conservant l'avantage de la densité maximale d'intégration, évite l'apparition de "claquages" prématurés dans ces régions aux tensions élevées, et réduit l'influence des diffusions parasites dues à d'inévitables trous dans la silice de masquage.

C'est encore un autre objet de l'invention que de proposer un procédé de fabrication de transistors qui se prête particulièrement bien à un alignement précis, par masquage composé, des murs latéraux d'isolement des transistors entre eux, et des régions p servant de base pour le transistor npn, d'émetteur pour le transistor pnp, et d'émetteur et collecteur pour le transistor pnp latéral.

Plus précisément, l'invention se rapporte à un transistor bipolaire à tension élevée, comportant une région d'émetteur, une région de base et une région de collecteur, supporté par un substrat de type de conductivité p, caractérisé en ce que la région qui a une jonction commune avec le substrat présente un taux de dopage de type de conductivité n, de valeur croissante dans le sens région-substrat, transistor caractérisé de plus en ce que la région de base présente, dans sa partie adjacente à la région d'émetteur, un taux de dopage de type de conductivité n croissant dans le sens collecteur-émetteur.

Dans son fondement, l'invention fait appel, pour la réalisation d'un transistor pnp à haute tenue en tension, à un surdopage local de la base dans sa portion voisine du collecteur, ce surdopage étant compatible avec la réalisation d'un transistor npn ; elle fait de plus appel à un dopage préalable de la région d'émetteur p des transistors pnp latéraux, par un dopant de type n, afin d'obtenir, après réalisation de l'émetteur p, un taux de dopage n de la base allant en croissant depuis le collecteur jusqu'à l'émetteur.

Cette seconde disposition a, de plus, l'avantage d'améliorer les autres performances de ces deux types de transistors, telles que la fréquence de coupure, le rapport signal sur bruit et une meilleure conservation de ces paramètres en fonction du choix du régime des courants.

L'invention sera mieux comprise à l'aide de la description ci-après, et en s'appuyant sur les figures jointes, où :

- la figure 1 représente, suivant une vue en coupe, quatre types de transistors connus, (npn),

4

(pnp), (pnp latéral) et "I2L" réunis sur un substrat semiconducteur suivant les procédés connus d'intégration monolithique ;

- la figure 2 représente, suivant une vue en coupe, les mêmes types de transistors, modifiés selon l'invention pour leur conférer une haute tenue en tension élevée ;

- la figure 3 représente, suivant des vues en coupe latérale de (a) à (j), la succession des étapes du procédé de fabrication des transistors modifiés selon l'invention.

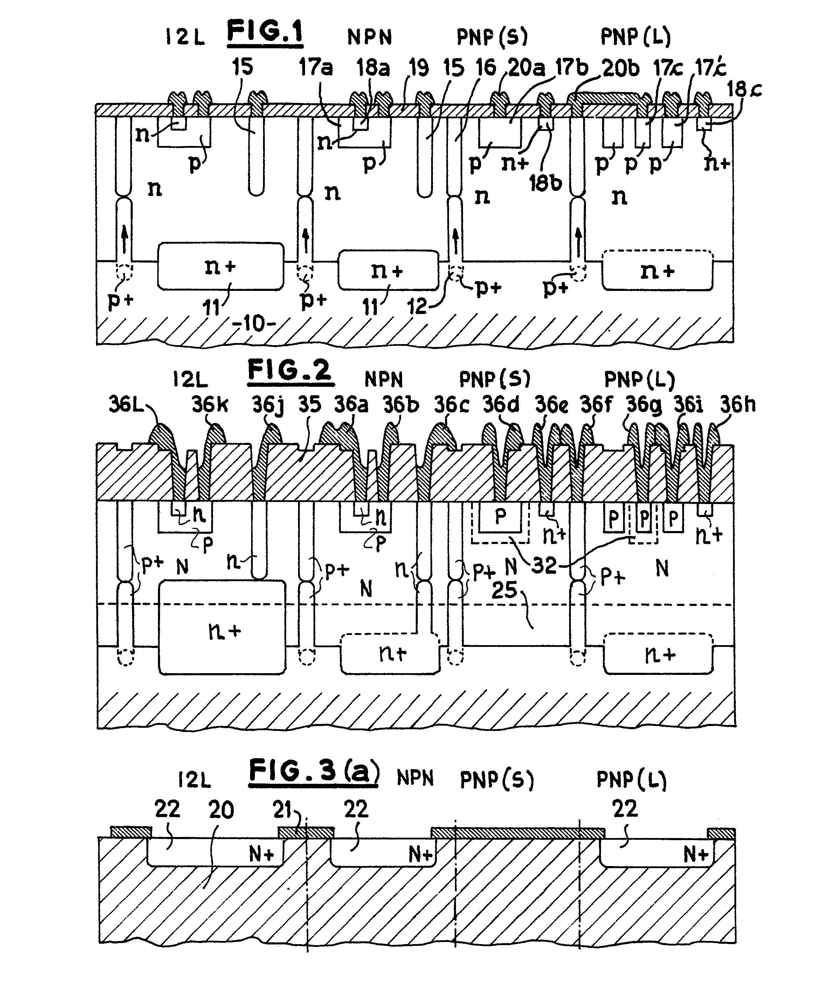

La figure 1 représente suivant une vue en coupe, quatre transistors de structure connue, respectivement de type "Integrated Injection Logic", ou I2L, de type (n-p-n), de type (p-n-p) et de type (p-n-p) "latéral", réalisés sur un substrat semiconducteur suivant les techniques d'intégration monolithique connues.

Le procédé de réalisation est le suivant, :

Dans un substrat 10, de silicium de type p par exemple, une couche enterrée 11 de type $n^+$ est diffusée après oxydation et photogravure correspondante. Une nouvelle photogravure est effectuée pour permettre l'implantation d'une fondation d'isolement $p^+$ 12 au niveau des murs d'isolement. Une couche épitaxiale 14 de type n est déposée. Une couche d'oxyde est alors produite puis photogravée pour permettre la diffusion du puits collecteur +n 15. La diffusion d'isolement 16 $p^+$ est effectuée après photogravure correspondante. Simultanément le bore provenant de la fondation d'isolement $p^+$ 12 diffuse vers le haut pour former la zone 13. Les couches 13 et 16 se rejoignent pour former l'isolement, environ vers le milieu de la couche épitaxiée. Cette méthode d'isolement composé est particulièrement intéressante pour les fortes épaisseurs d'épitaxie, ce qui est le cas pour les circuits haute tension, car elle permet une réduction des traitements thermiques et donc aussi des diffusions latérales. Mais le traitement thermique de l'isolement est aussi utilisé pour mettre en place la diffusion puits collecteur, dont le rôle est de réduire la résistance-série du transistor npn (région 15 de la figure 1). Mais, puisque cette diffusion s'effectue seulement à partir de la surface, elle n'atteint pas la couche enterrée et le résultat complet n'est pas obtenu : l'espace résiduel entre la diffusion et la couche enterrée introduit une augmentation de résistance collecteur évidemment très gênante : diminution du gain et de la fréquence de coupure, augmentation de la tension résiduelle collecteur-émetteur, augmentation des temps de propagation.

Après une autre étape de photogravure des régions de type p 17a, 17b, 17c et 17c' sont diffusées. La région 17a constitue la base du npn, la région 17b l'émetteur du pnp substrat, et les régions 17c et 17c' l'émetteur et le collecteur respectivement du pnp latéral. Une photogravure suivie de diffusion de type $n^+$ 18a, 18b et 18c est effectuée. La zone 18a est l'émetteur du npn et les zones 18b et 18c assurent une résistance de contact de base correcte pour les pnp. Après ouverture de l'oxyde 19 au niveau de l'ensemble des contacts, le réseau d'interconnexions 20 est formé.

Les conditions nécessaires à une augmentation de la tenue en tension npn du transistor font appel à des dispositions connues : d'abord, une augmentation de certaines dimensions, en vue de permettre à la zone de charge d'espace correspondant à la jonction collecteur-base de s'étendre, d'une part, plus librement (distances base-isolement et base-puits collec-

6

teur, épaisseur épitaxiée de la couche), et d'autre part, plus régulièrement (profondeur de jonction, pour diminuer la courbure de la zone de charge d'espace).

De plus, il est utile de diminuer le dopage du collecteur, c'est-à-dire de la couche épitaxiée ; pour une tenue en tension collecteur-émetteur de 120 V, avec un gain statique en courant de 100, ce dopage ne peut être supérieur à $5.10^{14}$ At/cm$^2$.

Mais cette même région épitaxiale constitue aussi la base du pnp substrat. Dans cette dernière, la zone de charge d'espace correspondant à la jonction entre couche épitaxiée et substrat se développe rapidement et le phénomène de perçage intervient prématurément. Pour l'éviter, il serait tentant d'augmenter l'épaisseur de la couche épitaxiale, solution ne pouvant cependant être retenue, car elle se traduit par une augmentation de la durée des traitements thermiques qui sont déjà considérables, et qui entraînent des diffusions latérales trop importantes. De plus ce supplément d'épitaxie serait préjudiciable aux caractéristiques du npn (tension de saturation, fréquence de coupure, etc.).

Enfin, dans le cas du transistor pnp latéral, existent les mêmes limitations ; sa tenue en tension dépend de la distance entre les diffusions de type p jouant les rôles d'émetteur et de collecteur. Pour satisfaire les exigences de tenue en tension, cette distance devient telle que les caractéristiques (gain statique, fréquence de coupure, etc.) sont médiocres.

Une dernière limitation à la montée en haute tension, est liée à l'existence d'effets parasites du type "effet de champ" MOS. En effet, dans le mode de réalisation connu, correspondant à la figure 1, la couche d'oxyde 19 sert à la fois de masque de diffusion et de passivation. Elle est généralement produite par oxydation du silicium et son épaisseur ne dépasse généralement pas 1,5 micron. Dans ces conditions, des MOS parasites apparaissent, induits entre un mur d'isolement et une couche diffusée p, par une connexion telle que 20b portée à un potentiel négatif ; leur tension de seuil est relativement faible, et ne dépasse pas 40 volts, ce qui est encore une limitation supplémentaire.

La figure 2 représente, suivant une vue en coupe, les quatre transistors correspondant à la figure 1, mais possédant une structure selon l'invention.

L'amélioration de la tenue en tension des pnp-substrats, suivant le fondement de l'invention, réside dans l'élaboration d'une nouvelle région, de même type que la couche épitaxiale servant de base, mais plus dopée, et placée entre le substrat et la région diffusée p servant d'émetteur à ce transistor. Elle a pour effet de repousser dans le substrat, l'extension de la zone de charge d'espace correspondant à la jonction entre couche épitaxiale et substrat, c'est-à-dire la jonction base-collecteur du pnp substrat. Pour remplir pleinement ce rôle, la nouvelle région doit être continue, entourer complètement l'émetteur du transistor ou au moins atteindre les murs d'isolement, afin de ne pas laisser entre l'émetteur et le substrat un chemin au travers duquel la zone de charge d'espace s'étendrait librement.

Pour réaliser un tel entourage l'invention fait appel, suivant une première caractéristique, à un profil d'épitaxie contrôlé, ou fait de plusieurs couches : par exemple une première couche de l'ordre de 1 μ d'épaisseur et de 0,3 Ω.cm de résistivité puis une deuxième couche dont les caractéristiques sont imposées par le transistor npn.

8

Mais il est bien préférable, du point de vue de la reproductibilité industrielle d'effectuer une implantation de type n dans le substrat près de la surface, et de réaliser ensuite l'épitaxie en une seule étape. La dose implantée est déterminée de façon à ne pas créer un risque de claquage prématuré au niveau des murs d'isolement. Cette méthode apporte un gain en tenue en tension d'une vingtaine de volts pour le pnp substrat, sans nuire aux caractéristiques du npn.

Suivant une deuxième caractéristique, l'invention fait appel, d'une manière qui peut être utilisée conjointement avec la première, et améliore encore les résultats, à un renforcement du dopage de l'épitaxie au voisinage de la jonction émetteur-base. Cela est obtenu en effectuant, avant la diffusion émetteur de type p, une implantation de type n en utilisant le même masque. On obtient ainsi un transistor doté d'un champ accélérateur dans la base, avec tous les avantages que cela comporte (meilleure tenue en haute tension, fréquence de coupure plus élevée, conservation du gain en fonction du courant, etc.). Cette disposition s'applique également au transistor pnp latéral et lui procure les mêmes améliorations.

Suivant une troisième caractéristique, des fondations pour puits-collecteur sont établies dans le substrat. Durant le traitement thermique d'isolement, après l'épitaxie, les fondations puits collecteurs diffusent aussi vers le haut et viennent rejoindre la zone diffusant à partir de la surface, assurant ainsi une faible résistance collecteur. Il est à noter que dans le cas de circuits comportant une partie I2L, la fondation puits collecteur est avantageusement étendue à toute la surface de la couche enterrée pour chaque transistor I2L. Les performances sont alors considérablement augmentées par suite de l'accroissement de l'efficacité d'injection, et de la réduction de la charge stockée au niveau de l'émetteur du transistor I2L.

Afin de tirer le meilleur parti des avantages procurés par ces dispositions, les distances entre murs d'isolement 16 et diffusions de type p 17 doivent être scrupuleusement respectées afin de ne pas avoir de claquage prématuré dans ces régions, tout en conservant la densité maximale d'intégration. Pour cela les zones 16 et 17 sont auto-alignées par masquage composé. Cette procédure améliore de plus le rendement, par suite de la réduction des diffusions parasites dues à d'inévitables trous dans la silice de masquage.

Enfin la tension de seuil des transistors MOS parasites est augmentée en effectuant un dépôt de silice épais avant l'ouverture des contacts pour interconnexions, mais en dopant l'oxyde déposé, suivant un dopage croissant en allant vers la surface. Il en résulte une gravure des contacts avec un profil contrôlé, ce qui conduit à la formation d'un réseau d'interconnexions hautement fiable, malgré l'importance de dénivellations dues à l'épaisseur de la couche de silice.

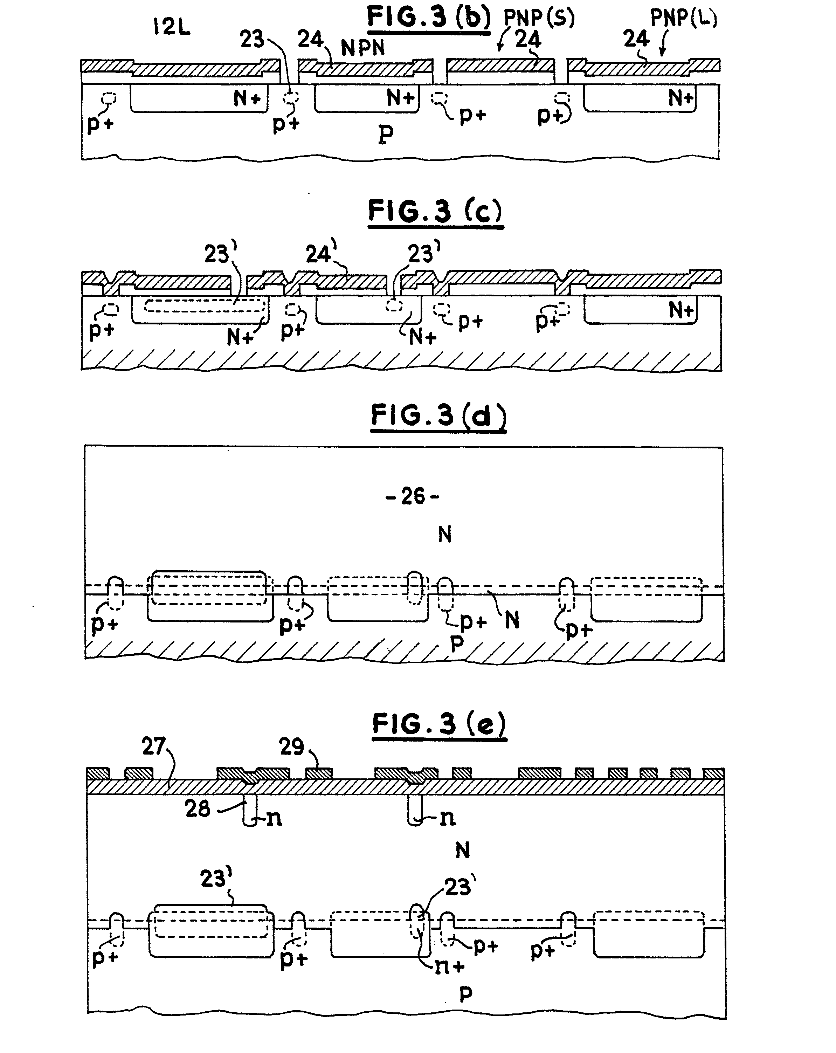

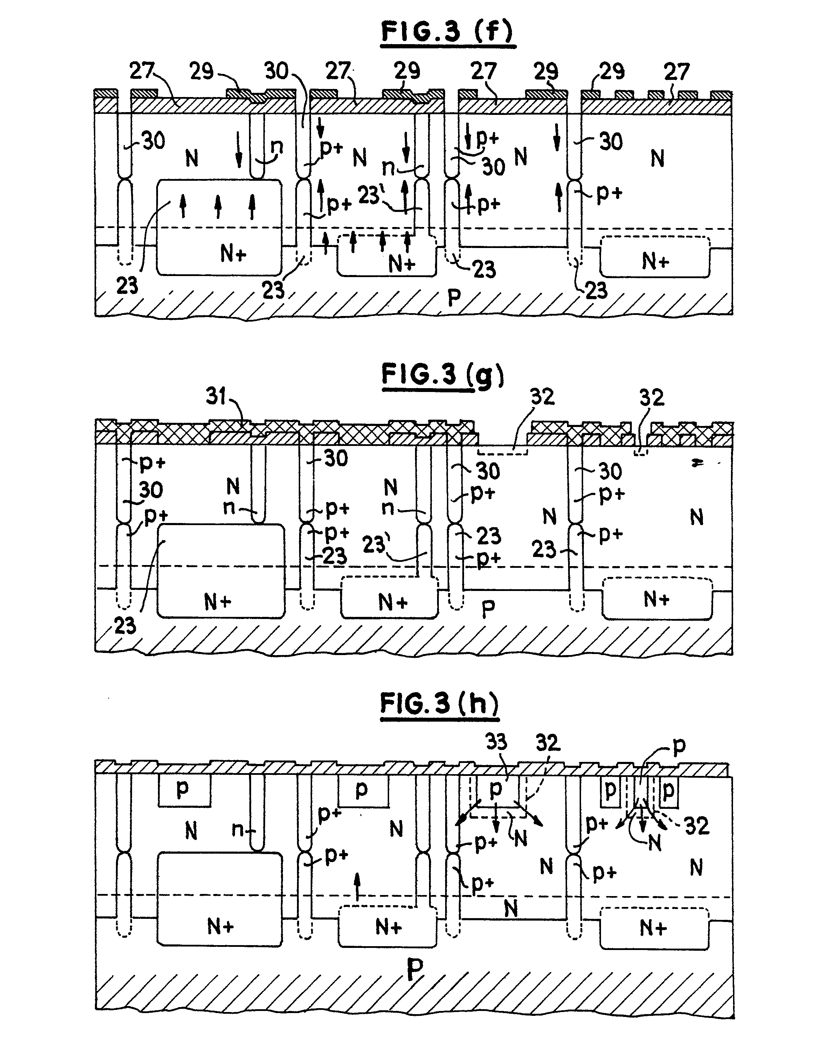

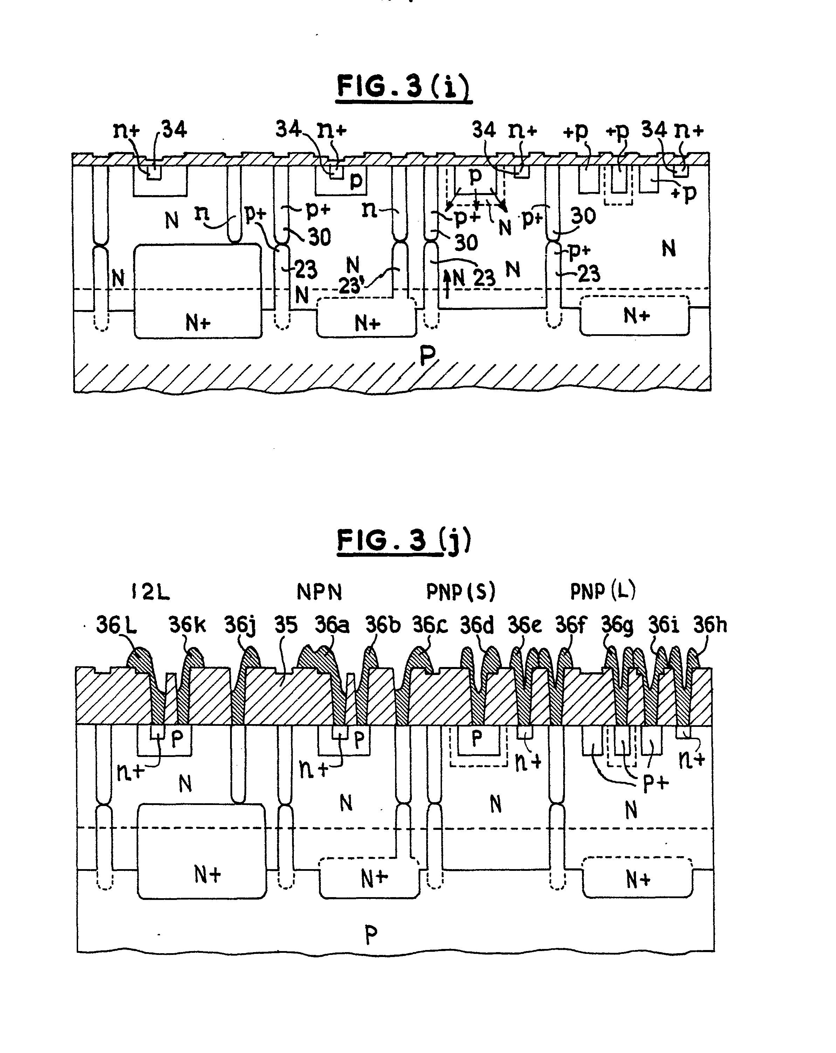

La figure 3 représente, sous forme de vues en coupe, les différentes étapes du procédé permettant de fabriquer un circuit intégré comportant les quatre types de transistors selon l'invention.

Un substrat de silicium 20 de type p est oxydé. Après photogravure de la couche d'oxyde 21, les futures couches enterrées $n^+$ 22 sont diffusées. Un traitement thermique en partie oxydant est effectué puis suit la photogravure correspondant aux murs d'isolement. Des fondations d'isolement $p^+$ 23 sont implantées en profondeur, la résine photosensible de masquage 24 étant conservée pendant cette opération afin d'éviter une éventuelle implantation parasite au niveau des couches enterrées $n^+$ (étape b). Après élimination de la résine, la photogravure correspondant aux fondations puits-collecteur $p^+$ est effectuée. Celles-ci sont alors implantées en 23' en utilisant encore le masquage par résine photosensible 24' (étape c).

Le silicium est alors entièrement désoxydé, et une région de type n 25 est implantée au voisinage de la surface. La dose est de l'ordre de $I.10^{11}$ At/$cm^2$. Une couche de type n 26 est épitaxiée (étape d). Les ordres de grandeur de ses caractéristiques sont 9$\Omega$/cm pour la résistivité et 21 microns pour l'épaisseur.

Une couche d'oxyde 27 est formée puis photogravée pour effectuer la diffusion puits collecteur 28 dans le transistor npn. Un traitement thermique oxydant assure une nouvelle croissance d'oxyde au-dessus de cette région diffusée. Une autre couche diélectrique 29 est formée (étape e). Elle peut être constituée soit par une augmentation de l'épaisseur de la couche 27, ce qui s'obtient par une continuation de l'oxydation thermique du silicium, soit par un dépôt de silice, de nitrure de silicium, etc. la figure e correspond au cas du nitrure de silicium. La couche 29 est photogravée au moyen d'un masque composé contenant d'une part les motifs correspondant aux murs d'isolement et d'autre part ceux correspondant aux diffusions p (base npn, émetteur pnp substrat, émetteur et collecteur pnp latéral). La gravure du nitrure de silicium s'effectue par exemple dans un plasma de fréon. A l'aide d'un masque de sélection, contenant les motifs murs d'isolement, mais dont les contours sont agrandis d'une valeur égale à l'erreur systématique maximale d'alignement, l'oxyde 27 est gravé au niveau des murs d'isolement (étape f) et ces derniers 20 sont diffusés. Pendant ce traitement thermique, les fondations d'isolement 23 et les fondations puits collecteur 23bis diffusent vers le haut. La couche 29 est gravée à l'aide d'un masque de sélection contenant les motifs correspondant aux diffusions p, avec des contours agrandis de la même façon que pour le masque sélection murs d'isolement. Après cette opération la couche de nitrure 29 est de préférence éliminée.

Une nouvelle sélection des diffusions p pour les émetteurs des pnp est opérée avec un simple masquage par résine photosensible 31 (étape g).

Une dose de phosphore de l'ordre de $5.10^{12}$ At/cm$^2$ est implantée en 32. Après élimination de la résine, une diffusion de type 33 est effectuée. Elle est suivie d'un traitement thermique oxydant pendant lequel la zone 32 diffuse également (étape h).

La photogravure correspondant à l'émetteur des npn et aux contacts de base des npn est alors effectuée. On procède ensuite à la diffusion des régions $n^+$ 34 (étape i). Cette diffusion étant généralement produite à partir de $POCI_3$, elle s'accompagne de la formation d'un verre dopé au phosphore.

Etant donné la vitesse de gravure importante de ce verre par rapport à celle de la silice, il doit être éliminé par une désoxydation partielle.

La création d'une couche de silice protectrice sur l'émetteur est suivie d'un dépôt d'une couche de silice 35, de l'ordre de 3,5 microns d'épaisseur. Cette couche est dopée, par exemple avec du phosphore, de façon croissante en allant du bas vers le haut. Cette répartition permet d'obtenir une gravure des contacts en biseau. On pourrait également utiliser comme diélectrique une couche de nitrure de silicium déposée à faible température. Il ne reste plus qu'à

12

former le réseau d'interconnexions 36 conformément à l'étape j. L'émetteur, la base et le collecteur du npn sont connectés par 36a, 36b, 36c, l'émetteur, la base et le collecteur du pnp substrat par 36d, 36e, 36f, et enfin l'émetteur, la base et le collecteur du pnp latéral par 36g, 36h et 36i. L'émetteur, la base et le collecteur du npn I2L sont connectés respectivement par 36j, 36k et 36l.

Par rapport aux transistors réalisés par les procédés connus d'intégration monolithique, les transistors selon l'invention ont manifesté les performances améliorées suivantes :

| Performances selon : | Tenues en tension collecteur-émetteur | | | Fréquences de coupure | |
|---|---|---|---|---|---|
| | pnp | pnp vertical | pnp latéral | pnp vertical | pnp latéral |
| Art antérieur | 150 V | 85 V | 45 V | 12 MHz | 8 MHz |
| Invention | 150 V | 155 V | 160 V | 65 MHz | 60 MHz |

13

REVENDICATIONS

1. Transistor bipolaire à tension élevée, comportant une région d'émetteur, une région de base et une région de collecteur, supporté par un substrat de type de conductivité p, caractérisé en ce que la région qui a une jonction commune avec le substrat présente un taux de dopage de type de conductivité n, de valeur croissante dans le sens région-substrat.

2. Transistor bipolaire selon la revendication 1, caractérisé en ce que la région de base présente, dans sa partie adjacente à la région d'émetteur, un taux de dopage de type de conductivité n croissant dans le sens collecteur-émetteur.

3. Transistor bipolaire selon l'une des revendications 1 ou 2, caractérisé en ce qu'il est du type pnp à collecteur-substrat.

4. Transistor bipolaire selon l'une des revendications 1 ou 2, caractérisé en ce qu'il est de type pnp à collecteur latéral.

5. Transistor bipolaire selon la revendication 1, caractérisé en ce qu'il est du type npn.

6. Transistor bipolaire selon la revendication 1, caractérisé en ce qu'il est du type dit "I2L".

7. Circuit intégré, caractérisé en ce qu'il comporte une pluralité de transistors selon l'une des revendications 1 et 2.

8. Circuit intégré selon la revendication 7, caractérisé en ce qu'il comporte un réseau d'interconnexions conductrices, déposé sur une couche de matériau isolant d'épaisseur égale ou supérieure à 1,5 micron.

9. Circuit intégré selon la revendication 8, caractérisé en ce que le matériau isolant est de la silice dopée, dont le taux de dopage est croissant en allant vers la surface de la couche.

10. Procédé de fabrication d'un circuit intégré selon la revendication 7, caractérisé en ce qu'il comporte les étapes suivantes :

a) sur le substrat semiconducteur de silicium de type p, création, par diffusion à travers les ouvertures d'un masque d'oxyde, de couches enterrées de type $n^+$ ;

b) création par implantation, à travers des ouvertures effectuées dans un masque, de fondations d'isolement $p^+$ avec conservation de la résine photosensible du masque ;

c) création par implantation, à travers d'autres ouvertures effectuées dans le masque d'oxyde, de fondations de puits collecteur $p^+$ ;

d) après mise à nu du substrat, étape caractéristique d'implantation à sa surface d'une région de type n fortement dopée, suivie d'un dépôt de silicium de type n par épitaxie ;

e) création, par diffusion à travers les ouvertures d'un masque d'oxyde, des puits collecteurs de ceux des transistors qui en comportent, et croissance d'une nouvelle couche de diélectrique sur la surface du substrat ;

f) création, par diffusion, à travers les ouvertures de la nouvelle couche diélectrique, des murs d'isolement entre les transistors ;

g) création, par implantation, à travers les ouvertures d'un masque de résine photosensible, correspondant aux régions p des transistors pnp et pnp latéral, comme étape caractéristique, de régions dopées n ;

h) création par diffusion, à travers les ouvertures d'un masque d'oxyde, des régions p servant de base pour les transistors npn et I2L, d'émetteur pour les transistors pnp, et d'émetteur et collecteur pour les transistors pnp latéral ;

i) création par diffusion, à travers les ouvertures d'un masque d'oxyde, des régions $n^+$ servant d'émetteur pour les transistors npn et I2L, et de contact de base pour les transistors pnp et pnp latéral.

**FIG.1**

12L  NPN  PNP(S)  PNP(L)

15  17a  18a  19  15  16  20a  17b  20b  17c  17c  18c

n  p  n  p  p  n+  p  p  p  n+  18b

n  n  n  n

n+  n+  n+  n+

p+  11  p+  11  12  p+  p+

-10-

**FIG.2**

12L  NPN  PNP(S)  PNP(L)

36L  36k  36j  35  36a  36b  36c  36d  36e  36f  36g  36i  36h

n  n  P  n+  P  P  P  n+

p+  N  n  p+  n  P+  N  32  P+  N

n+  25

n+  n+

**FIG.3(a)**  NPN  PNP(S)  PNP(L)

12L

22  20  21  22  22

N+  N+  N+

**FIG.3 (b)**

12L     23    24   NPN    PNP(S)   24     24   PNP(L)

p+    N+    p+    N+    p+    p+    N+

P

**FIG.3 (c)**

23'     24'     23'

p+    N+   p+    N+    p+    p+    N+

**FIG.3 (d)**

–26–

N

p+      p+     p+   N     p+

P

**FIG.3 (e)**

27     29

28   n     n

N

23'      23'

p+     p+     p+    p+

n+

P

## FIG.3 (f)

27    29    30    27    29    27    29    29    27

30    N    n    p+    N    n    p+    30    N    30    N

30    p+

p+    23'    N+    p+

23    23    N+    23    P    23

## FIG.3 (g)

31    32    32

p+    30    30    30

30    N    p+    N    p+    p+

p+    n    p+    23    n    23'    23    23    p+

N+    23    N+    P    N    N

## FIG.3 (h)

33    32    p

p    p    p    32

p    N    n    p+    N    p    N    p+

p+    N    p+

p+    N

N+    N+    N    N+

P

4/4

## FIG.3(i)

## FIG.3(j)

Office européen
des brevets

**RAPPORT DE RECHERCHE EUROPEENNE**

0009442
Numéro de la demande

EP 79 40 0640

| Catégorie | Citation du document avec indication, en cas de besoin, des parties pertinentes | Revendication concernée | CLASSEMENT DE LA DEMANDE (Int. Cl. 3) |
|---|---|---|---|
| | **DOCUMENTS CONSIDERES COMME PERTINENTS** | | |
| | FR - A - 2 173 729 (R.T.C.)  * Figures 1-4; revendications * | 1,2,5, 10 | H 01 L 29/72  H 01 L 21/82  H 01 L 29/10  H 01 L 27/02 |
| | -- | | |
| | DE - A - 2 603 746 (LICENCIA PATENT VERWALTUNGS GmbH)  * Figures 1-5; revendications * | 1,4,5, 7,10 | |
| | -- | | |
| | DE - A - 2 800 240 (RCA CORP.)  * Figures 1-9; page 7, ligne 6 - page 11 *  & FR - A - 2 377 704 | 1,5-7, 10 | DOMAINES TECHNIQUES RECHERCHES (Int. Cl. 3)  H 01 L 21/82  H 01 L 29/72  H 01 L 27/02  H 01 L 29/10  H 01 L 27/08  H 01 L 21/74 |
| | ---- | | |

CATEGORIE DES DOCUMENTS CITES

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

Le présent rapport de recherche a été établi pour toutes les revendications

| Lieu de la recherche | Date d'achevement de la recherche | Examinateur |
|---|---|---|
| La Haye | 11-12-1979 | CARDON |